# EUROPEAN PATENT APPLICATION

(11) **EP 4 629 754 A1**
(43) Date of publication of application: **08.10.2025**
(21) Application number: 25164494.4
(22) Date of filing: 18.03.2025
(51) Int. Cl.: H05K 1/02, H05K 3/00, H05K 3/46

(54) **OPTICAL MODULES AND ASSOCIATED METHODS OF CONSTRUCTING OPTICAL MODULES**

(30) Priority: 25.03.2024 US 202418615196
(71) Applicant: STMicroelectronics International N.V., 1228 Plan-les-Ouates, Geneva (CH)
(72) Inventor: NGUYEN, Wei Liang Keith, 343115 SINGAPORE (SG)
(74) Representative: Casalonga

(57) **Abstract**

In accordance with various embodiments of the present disclosure, an assembly (100) of a plurality of optical modules (200) is provided. The assembly (100) comprises a base layer (102), a cover layer (180), and a wall layer (120, 140, 160). The base layer (102) comprises one circuit board laminated substrate having a plurality of optical components mounted thereon. The cover layer (180) comprises one circuit board laminated substrate having a plurality of apertures (188, 190) defined therein. Each of the plurality of apertures correspond to a respective one of the plurality of optical modules (200) and align with a respective one of the plurality of optical components. The wall layer (120, 140, 160) is coupled to the base layer (102) and to the cover layer (180) and forms a plurality of external walls. The base layer (102), the cover layer (180), and the wall layer (120, 140, 160) together define a plurality of chambers (132), each corresponding to a respective one of the optical modules (200).

## Description

### FIELD OF THE INVENTION

Example embodiments of the present disclosure relate generally to optical modules and, more particularly, to construction methods for optical modules.

### BACKGROUND

Optical sensors are modules that contain and use one or more light sources and/or light receivers to detect the reflected light off a target object. The received light is used to extract useful information like distance, motion, surface properties, etc. The optical modules may include an enclosure formed by attaching a plastic housing with adhesive to a circuit board or other substrate to encapsulate one or more light sources and/or one or more light receivers. Lenses or other structures may be coupled to and/or integrated with the plastic housing.

Applicant has identified many technical challenges and difficulties associated with optical modules and the manufacturing thereof. For example, such optical modules are often manufactured as individual modules. This piece-by-piece assembly each individual module is inefficient and costly. Additionally, it is difficult to maintain consistency, in size and quality, across the assembly of large numbers of modules.

Through applied effort, ingenuity, and innovation, Applicant has solved problems related to such optical modules by developing solutions embodied in the present disclosure, which are described in detail below.

### BRIEF SUMMARY

Various embodiments described herein related to optical module assemblies and methods for constructing a plurality of optical modules as an assembly.

In accordance with various embodiments of the present disclosure, an assembly of a plurality of optical modules is provided. In some embodiments, the assembly comprises a base layer, and cover layer, and a wall layer. The base layer comprises one circuit board laminated substrate having a plurality of optical components mounted thereon, each of the plurality of optical components corresponding to a respective one of the plurality of optical modules. The cover layer is substantially parallel to the base layer and comprises one circuit board laminated substrate having a plurality of apertures defined therein. Each of the plurality of apertures correspond to a respective one of the plurality of optical modules and align with a respective one of the plurality of optical components. The wall layer is coupled to the base layer and to the cover layer and forms a plurality of external walls for each of the plurality of optical modules. The base layer, the cover layer, and the wall layer together define a plurality of chambers, each of the plurality of chambers corresponding to a respective one of the plurality of optical modules.

In some embodiments, the wall layer comprises at least one circuit board laminated substrate.

In some embodiments, the wall layer comprises a plurality of sub-layers, each of the plurality of sub-layers comprising one circuit board laminated substrate.

In some embodiments, one or more of the plurality of sub-layers form one or more interior walls for each of the plurality of optical modules to divide each chamber of the plurality of optical modules into two or more sub-chambers.

In some embodiments, at least one of the one or more interior walls for each of the plurality of optical modules does not span from the base layer to the cover layer.

In some embodiments, the wall layer and/or at least one of the one or more interior walls for each of the plurality of optical modules form one or more mounting surfaces for a lens and/or a filter in each of the plurality of optical modules.

In some embodiments, a plurality of conductive vias are formed in the wall layer to conductively connect the base layer and the cover layer.

In some embodiments, at least one of the plurality of conductive vias forms a portion of an electric circuit for detecting displacement of the cover layer and/or displacement of a lens in each of the plurality of optical modules.

In some embodiments, the wall layer comprises a unitary wall layer formed on or affixed to the base layer and/or the cover layer.

In some embodiments, the assembly further comprises a plurality of lenses affixed to an underside of the cover layer. Each of the plurality of lenses is aligned with a respective one of the plurality of apertures. At least a portion of an innermost sub-layer of the cover layer is removed to define an air vent from each chamber of each of the plurality of optical modules to a respective one of the plurality of apertures.

In accordance with various embodiments of the present disclosure, a method of constructing a plurality of optical modules is provided. In some embodiments, the method comprises constructing an assembly of a plurality of optical modules by coupling a base layer and a cover layer to a wall layer and singulating the assembly into separate optical modules. The base layer comprises one circuit board laminated substrate having a plurality of optical components mounted thereon. Each of the plurality of optical components corresponds to a respective one of the plurality of optical modules. The cover layer is substantially parallel to the base layer and comprises one circuit board laminated substrate having a plurality of apertures defined therein. Each of the plurality of apertures corresponds to a respective one of the plurality of optical modules and aligns with a respective one of the plurality of optical components. The wall layer forms a plurality of external walls for each of the plurality of optical modules. The base layer, the cover layer, and the wall layer together define a plurality of chambers, each of the plurality of chambers corresponding to a respective one of the plurality of optical modules.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a top perspective view of an example base layer of an example assembly of four optical modules, in accordance with some embodiments of the present disclosure;
FIG. 2 is a top perspective view of the example partial optical module assembly of FIG. 1 with an example first wall sub-layer added, in accordance with some embodiments of the present disclosure;
FIG. 3 is a top perspective view of the example partial optical module assembly of FIG. 2 with an example second wall sub-layer added, in accordance with some embodiments of the present disclosure;
FIG. 4 is a bottom perspective view of an example third wall sub-layer to be added to the example partial optical module assembly of FIG. 3, in accordance with some embodiments of the present disclosure;
FIG. 5 is a top perspective view of the example partial optical module assembly of FIG. 3 with the example third wall sub-layer of FIG. 4 added, in accordance with some embodiments of the present disclosure;
FIG. 6 is a bottom perspective view of an example cover layer to be added to the example partial optical module assembly of FIG. 5, in accordance with some embodiments of the present disclosure;
FIG. 7 is a bottom perspective view of the example cover layer of FIG. 6 with example optical lenses and/or filters added, in accordance with some embodiments of the present disclosure;
FIG. 8 is a top perspective view of an example completed optical module assembly, in accordance with some embodiments of the present disclosure;
FIG. 9 is a top perspective view of the example optical module assembly of FIG. 8 singulated into four separate optical modules, in accordance with some embodiments of the present disclosure; and
FIG. 10 is a bottom perspective view of an example cover layer of an example assembly of four optical modules coupled with a unitary wall layer, in accordance with some alternative embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Various embodiments of the present disclosure overcome the above technical challenges and difficulties and provide various technical improvements and advantages based on, for example, but not limited to, constructing a plurality of optical modules together as an assembly and then singulating the assembly into individual optical modules. In this regard, consistency of the size and quality of the individual optical modules is readily maintained which aids in handling and mounting of the modules. In various embodiments, a large number (e.g., many hundreds) of optical modules are constructed as a single assembly and then singulated into individual optical modules.

In various embodiments of the present disclosure, the assembly of a plurality of optical modules is constructed in layers. In some example embodiments, an assembly of a plurality of optical modules comprises three layers: a base (i.e., bottom) layer, a cover (i.e., top) layer, and a wall layer therebetween. In other example embodiments, the wall layer comprises two or more sub-layers such that the assembly of a plurality of optical modules comprises four or more layers (i.e., base layer, cover layer, and two or more wall sub-layers). Once singulated, the base layer, the cover layer, and the wall layer or sub-layers form the housing of each individual optical module.

In various embodiments, the various layers are stacked and adhered to each other using any suitable adhesive. In some embodiments, the adhesive may comprise a conductive adhesive. In various embodiments, components may be pre-attached to the relevant layers before the layers are stacked and adhered to each other. Such components include, but are not limited to, light sources, light receivers, lenses, filters, etc.

In various embodiments of the present disclosure, one or more of the layers of such an assembly of a plurality of optical modules each comprise a standard circuit board substrate laminate. In some embodiments, one or more of the layers comprise copper clad laminate (CCL). CCL comprises layers of copper foil laminated onto both major sides of an insulation (core) layer. The core layer may comprise resin, glass fabric, and the like.

In some embodiments, all of the layers (base layer, cover layer, wall layer or sub-layers) are constructed of standard circuit board substrate laminate material. In other embodiments, one or more of the layers may be constructed of any other suitable material. For example, if conductivity of the wall layer(s) (discussed below) is not required, the wall layer may be a unitary structure constructed of any suitable material, such as any suitable plastic. In some such embodiments, the wall layer may be directly formed onto the base layer or onto the cover layer using a formative or additive process, for example but not limited to transfer molding, screen printing, 3D printing, and/or the like. In other such embodiments, the wall layer may be formed separately from the base layer or the cover layer using a formative or additive process or any other suitable process (e.g., injection molding) and then affixed to the base layer or the cover layer.

In various embodiments, each layer or sub-layer that is constructed of circuit board substrate laminate material is constructed of a single circuit board substrate laminate material that forms that layer or sub-layer for all of the optical modules of the assembly. Forming each layer from a single substrate ensures consistency among all of the optical modules of the assembly.

In various embodiments, one or more openings may be created (e.g., drilled or routed) in one or more of the layers prior to stacking the layers. For example, large openings are typically routed into the wall layer or sub-layers such that the wall layer or sub-layers define chambers for the electronic components of each optical module. As another example, openings are typically drilled or routed into the cover layer to define one or more apertures for light to be emitted from or received into each optical module. In various embodiments, one or more of the apertures comprise a plated through-hole.

While embodiments of the present disclosure are described herein as constructed from standard circuit board substrate laminate material, such as CCL, other embodiments may use other forms of substrates, for example ceramic substrates, polymer-based laser direct structuring (LDS) substrates, etc.

Once assembled, the optical module assembly of various embodiments is singulated into individual optical modules using any suitable singulation process, such as sawing.

In various embodiments, a plurality of conductive vias are formed in the wall layer or sub-layers to conductively connect the base layer and the cover layer. In this regard, the base, walls, and cover of each optical module together form a Faraday cage that prevents or limits electromagnetic interference (EMI) from entering and/or leaving each optical module. In various embodiments, one or more conductive vias are formed in the wall layer or sub-layers to form a portion of an electric circuit for detecting displacement of the cover layer and/or displacement of a lens in each of the plurality of optical modules. In various embodiments, the one or more conductive vias for forming a portion of an electric circuit for detecting displacement of the cover layer and/or displacement of a lens are separate from the plurality of conductive vias formed in the wall layer or sub-layers to conductively connect the base layer and the cover layer.

In various embodiments, the wall layer or one or more of the wall sub-layers form one or more interior walls for each optical module, thereby defining two or more sub-chambers within each optical module. In some embodiments, an interior wall spans from the base layer to the cover layer. In some other embodiments, an interior wall does not span from the base layer to the cover layer, such that an opening is provided between two sub-chambers to allow, for example, for an electronic component to span two sub-chambers.

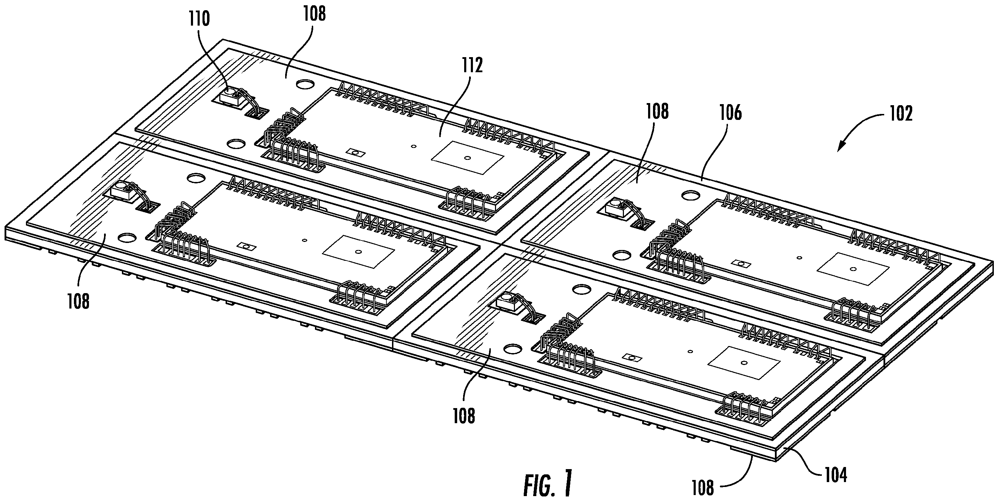

Referring now to the figures, FIGS. 1-8 illustrate various steps of constructing an example assembly of four modules in accordance with some embodiments of the present disclosure. While the figures illustrate constructing an optical assembly of four optical modules for simplicity, embodiments of the present disclosure may involve constructing an optical assembly of any suitable number of optical assemblies (e.g., many hundreds or more).

FIG. 1 is a top perspective view of an example base layer 102 of an example assembly of four optical modules. The example base layer 102 is created using a single substrate of electrical circuit board material, such as CCL, created using conventional circuit board construction methods. As seen in FIG. 1, the substrate of electrical circuit board material comprises a composite core 104, a copper layer 106 on top of the core 104 (there may also be a copper layer on the bottom of the core (not illustrated)), and a solder mask 108 on top of the copper layer 106. The base layer 102 includes a plurality of electronic components for each of the four modules being constructed, such as a light emitter 110 (which may comprise, for example, a vertical-cavity surface-emitting laser (VCSEL)) and an integrated circuit 112 (which may function as a light receiver), connected via wirebonds to the copper layer 106. Since the construction of an assembly of four optical modules is illustrated, the base layer 102 includes four each of the components and circuitry required for each individual optical module.

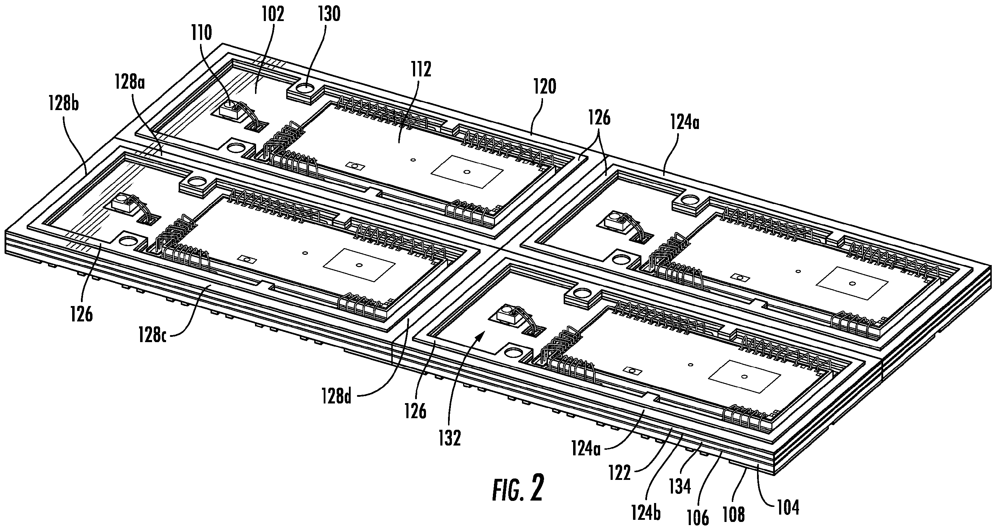

FIG. 2 is a top perspective view of an example partial optical module assembly with an example first wall sub-layer 120 added on top of the base layer 102 of FIG. 1. As with the base layer 102, the first wall sub-layer 120 is created using a single substrate of electrical circuit board material, such as CCL, created using conventional circuit board construction methods. As seen in FIG. 2, the substrate of electrical circuit board material used to create the first wall sub-layer 120 comprises a composite core 122, a top copper layer 124a on top of the core 122, a bottom copper layer 124b on the bottom of the core 122, and a solder mask 126 on top of the top copper layer 124a.

As seen in FIG. 2, four openings are defined in the first wall sub-layer 120, such that the first wall sub-layer 120 forms a framework that begins to form what will become the exterior walls 128a-d of the four optical modules when singulated and begins to form the chambers 132 of the optical modules.

In various embodiments, the first wall sub-layer 120 is adhered to the base layer using an adhesive 134 around all of the edges. Any suitable adhesive may be used, such as a conductive adhesive if the side walls are conductive between the base layer and the cover layer (i.e., if the side walls have conductive vias).

One or more conductive vias 130 may be formed in the first wall sub-layer 120 for each of the optical modules, such as to form a portion of an electric circuit for detecting displacement of the cover layer and/or displacement of a lens in each of the plurality of optical modules as described further below.

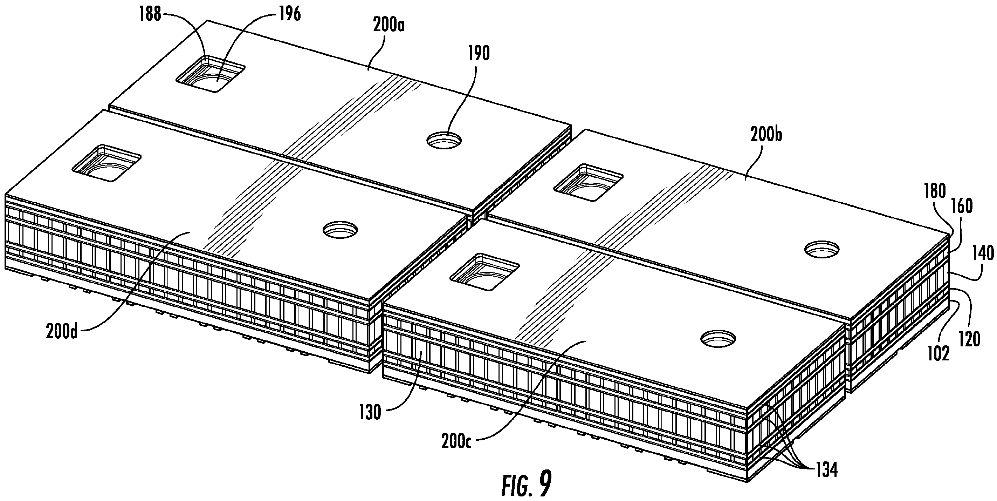

The first wall sub-layer 120 may comprise a plurality of conductive vias (seen exposed after singulation in FIG. 9) formed around all of areas that will become the exterior walls 128a-d of the four optical modules to conductively connect the base layer 102 and the cover layer (described below) to form a Faraday cage.

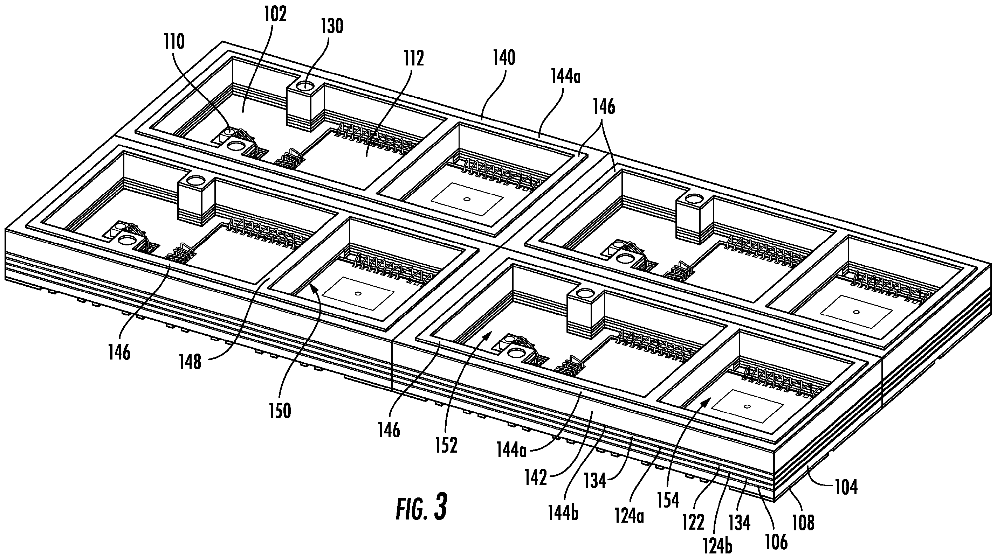

FIG. 3 is a top perspective view of the example partial optical module assembly of FIG. 2 with an example second wall sub-layer 140 added on top of the first wall sub-layer 120. As with the base layer 102 and the first wall sub-layer 120, the second wall sub-layer 140 is created using a single substrate of electrical circuit board material, such as CCL, created using conventional circuit board construction methods. As seen in FIG. 3, the substrate of electrical circuit board used to create the second wall sub-layer 140 material comprises a composite core 142, a top copper layer 144a on top of the core 142, a bottom copper layer 144b on the bottom of the core 142, and a solder mask 146 on top of the top copper layer 144a.

As with the first wall sub-layer 120, four openings are defined in the second wall sub-layer 140, such that the second wall sub-layer 140 also forms a framework that continues to form what will become the exterior walls 128a-d of the four optical modules when singulated and continues to form the chambers 132 of the optical modules. In various embodiments, the second wall sub-layer 140 is adhered to the first wall sub-layer 120 using the adhesive 134 around all of the edges.

As with the first wall sub-layer 120, one or more conductive vias 130 may be formed in the second wall sub-layer 140 for each of the optical modules, such as to continue to form a portion of an electric circuit for detecting displacement of the cover layer and/or displacement of a lens.

As with the first wall sub-layer 120, the second wall sub-layer 140 may comprise a plurality of conductive vias (seen exposed after singulation in FIG. 9) formed around all of areas that will become the exterior walls of the four optical modules to conductively connect the base layer 102 and the cover layer (described below) to form a Faraday cage.

In the illustrated embodiment, the second wall sub-layer 140 begins to form an interior wall 148 for each optical module, thereby dividing the chambers 132 of each optical module into two sub-chambers 152, 154. In the illustrated embodiment, the interior walls 148 do not contact the base layer, such that an opening or gap 150 is provided under each interior wall 148 and between the two sub-chambers 152, 154 of each optical module to allow the integrated circuit 112 to span the two sub-chambers 152, 154. Such interior walls may reduce crosstalk between the light emitter and the light receiver. Such interior walls may provide, for example, mounting surfaces for components such as lenses and/or filters, as well as providing strength and rigidity to the housing of each module.

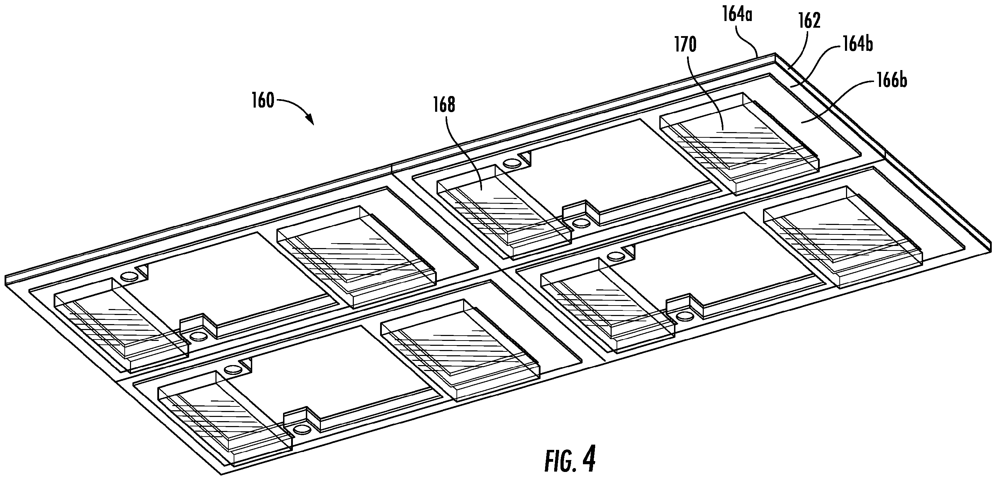

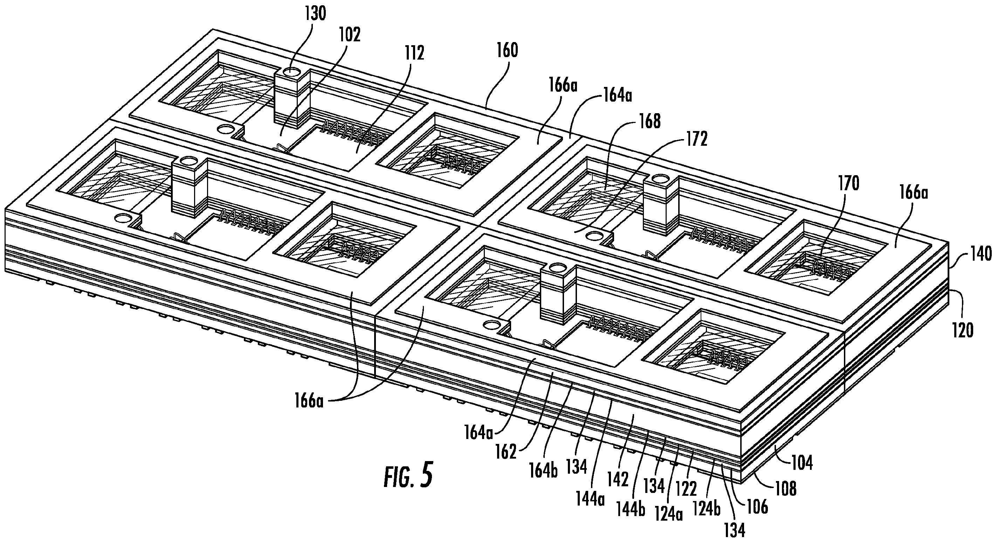

FIG. 4 is a bottom perspective view of an example third wall sub-layer 160 to be added on top of the second wall sub-layer 140. FIG. 5 is a top perspective view of the example partial optical module assembly of FIG. 3 with the example third wall sub-layer of FIG. 4 added on top of the second wall sub-layer 140. As with the base layer 102, the first wall sub-layer 120, and the second wall sub-layer 140, the third wall sub-layer 160 is created using a single substrate of electrical circuit board material, such as CCL, created using conventional circuit board construction methods. As seen in FIGS. 4 and 5, the substrate of electrical circuit board material used to create the third wall sub-layer 160 comprises a composite core 162, a top copper layer 164a on top of the core 162, a bottom copper layer 164b on the bottom side of the core 162, a top solder mask 166a on top of the top copper layer 164a, and a bottom solder mask 166b on the bottom copper layer 164b.

As with the first wall sub-layer 120 and the second wall sub-layer 140, four openings are defined in the third wall sub-layer 160, such that the third wall sub-layer 160 also forms a framework that continues to form what will become the exterior walls 128a-d of the four optical modules when singulated and continues to form the chambers 132 of the optical modules. In various embodiments, the third wall sub-layer 160 is adhered to the second wall sub-layer 140 using the adhesive 134 around all of the edges.

As with the first wall sub-layer 120 and the second wall sub-layer 140, one or more conductive vias 130 may be formed in the third wall sub-layer 160 for each of the optical modules, such as to continue to form a portion of an electric circuit for detecting displacement of the cover layer and/or displacement of a lens. This conductive via 130 enables an electrical connection between circuitry in a filter, a lens, and/or a cover layer and, for example, the integrated circuit 112 such that displacement of the filter, lens, or cover layer breaks the circuit. Such a break in the circuit can be detected by the integrated circuit 112, which can then stop the operation of the optical module.

As with the first wall sub-layer 120 and the second wall sub-layer 140, the third wall sub-layer 160 may comprise a plurality of conductive vias (seen exposed after singulation in FIG. 9) formed around all of areas that will become the exterior walls of the four optical modules to conductively connect the base layer 102 and the cover layer (described below) to form a Faraday cage.

In the illustrated embodiment, the third wall sub-layer 160 continues to form the interior wall 148 for each optical module.

In the illustrated embodiment, a first filter 168 and a second filter 170 are mounted to the underside of the third wall sub-layer 160, such that the first filter 168 filters the emitted light from the light emitter 110 and the second filter 170 filters the light to be received by the integrated circuit 112. The third wall sub-layer 160 comprises a plurality of mounting surfaces 172 for such filters. In various embodiments, any suitable number and type of filter may be used, and any suitable mounting arrangement may be used.

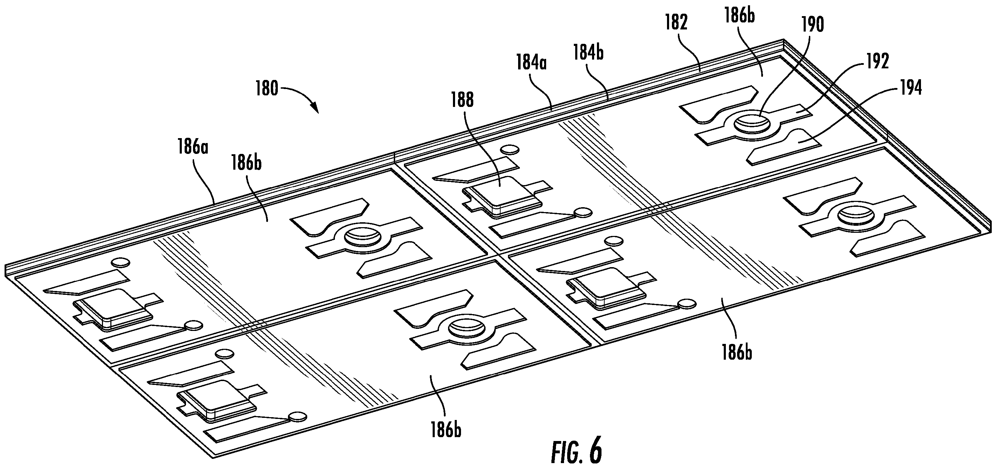

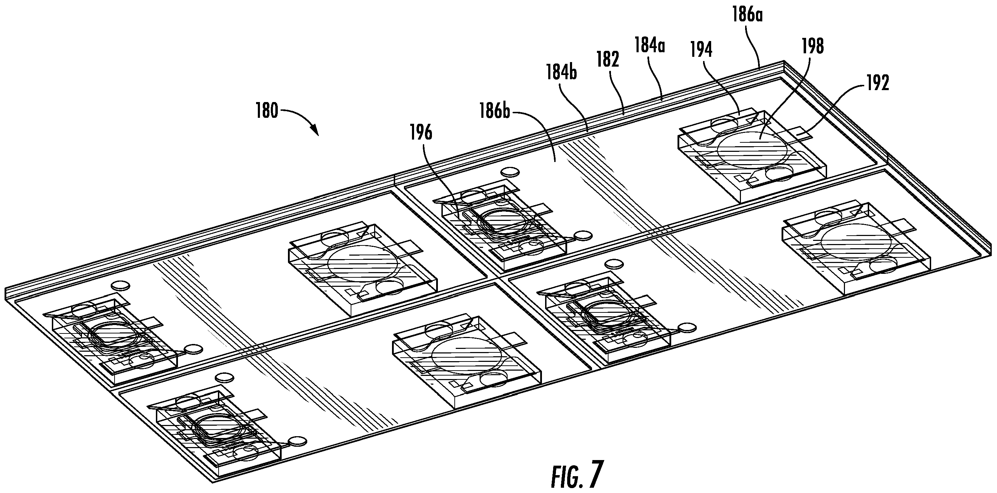

FIG. 6 is a bottom perspective view of an example cover layer 180 to be added on top of the third wall sub-layer 160. FIG. 7 is a bottom perspective view of the example cover layer 180 with example optical lenses (described further below) secured thereto. The cover layer 180 is created using a single substrate of electrical circuit board material, such as CCL, created using conventional circuit board construction methods. As seen in FIGS. 6 and 7, the substrate of electrical circuit board used to create the cover layer 180 material comprises a composite core 182, a top copper layer 184a on the top of the core 142, a bottom copper layer 184b on the bottom side of the core 182, a top solder mask 186a on the top copper layer 184a, and a bottom solder mask 186b on the bottom copper layer 184.

A plurality of openings are defined in the cover layer 180. In the illustrated embodiment, a first aperture 188 to allow light from the light emitter to exit and a second aperture 190 to allow light to enter and reach the light receiver are defined for each optical module. In the illustrated embodiment, each of the first apertures 188 are generally square and were created by routing the opening, while each of the second apertures 190 are generally round and were created by drilling the opening. However, such apertures may be any suitable shape and may be created using any suitable technique. Further, any suitable number and placement of apertures may be used. In various embodiments, one or both of the first and second apertures may be plated through-holes created by copper plating the cover layer after the apertures were routed/drilled.

In various embodiments, one or more optical lenses for each optical module may be adhered to the underside of the cover layer. Such lenses may, for example, help prevent foreign matter from entering the optical module through the apertures. As seen in FIG. 7, a first optical lens 196 is secured to the cover layer 180 positioned to span the first aperture 188 and a second optical lens 198 is secured to the cover layer 180 positioned to span the second aperture 190.

In various embodiments, some of the bottom solder mask 186b is removed from various areas of the underside of the cover layer 180 to create shallow voids for air vents and glue traps. In the illustrated embodiment, some of the bottom solder mask 186b abutting the second aperture 190 is removed to create an air vent 192 (a similar air vent (unlabeled) is created abutting the first aperture 188). As seen in FIG. 7, when the second optical lens 198 is adhered to the cover layer 180, the air vent 192 creates a gap between the second optical lens 198 and the cover layer 180 to allow air and/or moisture within the optical module to escape to the exterior. Air inside the optical module expands when the optical module heats up. Without such an air vent, the expanding air could not escape and could damage the module. The air vents of embodiments of the invention are sufficient to allow air escape but shallow enough to prevent foreign matter from entering the module.

. In the illustrated embodiment, some of the bottom solder mask 186b on opposing sides of the second aperture 190 is removed to create a glue trap 194. The shallow voids of the glue trap 194 receive the adhesive used to secure the second optical lens 198 to the cover layer 180, allowing the second optical lens 198 to sit flush against the cover layer 180.

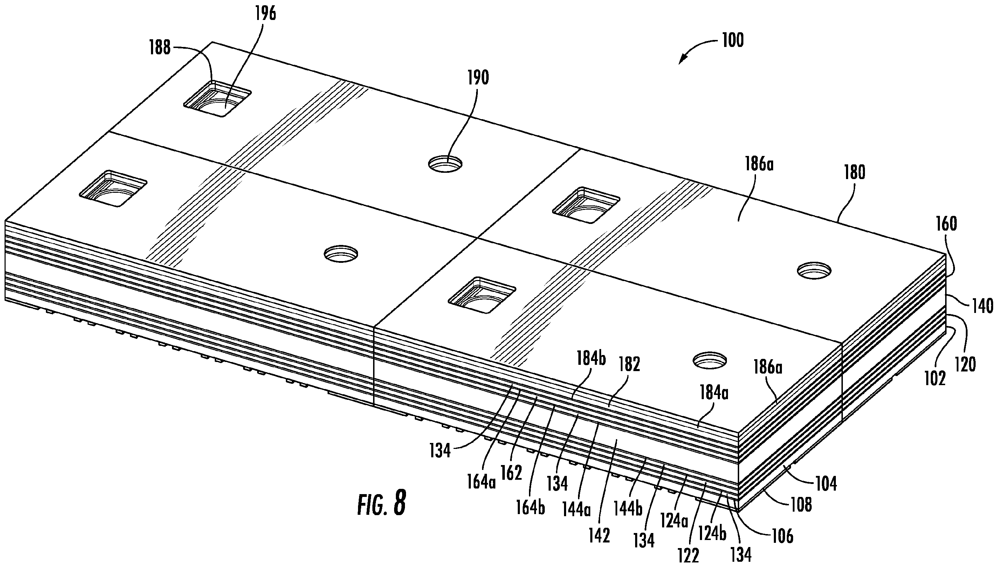

FIG. 8 is a top perspective view of an example completed optical module assembly after the example cover layer of FIGS. 6 and 7 has been added on top of the third wall sub-layer 160. The completed optical module assembly 100 of FIG. 8 comprises four complete optical modules that have not yet been singulated. In various embodiments, the completed optical module assembly 100 of FIG. 8 is singulated using any suitable mechanism or method for singulating.

FIG. 9 is a top perspective view of the example optical module assembly 100 of FIG. 8 singulated into four separate, complete optical modules 200a-d. The four separate, complete optical modules 200a-d are all identical, with consistent shapes and sizes to enable efficient handling and mounting of the modules into a device, such as a mobile phone. As seen in FIG. 9, the singulation process has cut away the outermost surfaces of the walls, exposing the conductive vias 130 that are positioned along all four sides of the optical modules. The conductive vias 130, in conjunction with the layers of conductive adhesive 134, provide an electrical connection between the top copper layer 106 of the base layer 102 and the bottom copper layer 184b of the cover layer 180. The conductive vias 130, the copper layer 106 of the base layer 102, and the bottom copper layer 184b of the cover layer 180 thus form a Faraday cage that prevents or limits electromagnetic interference (EMI) from entering and/or leaving each optical module.

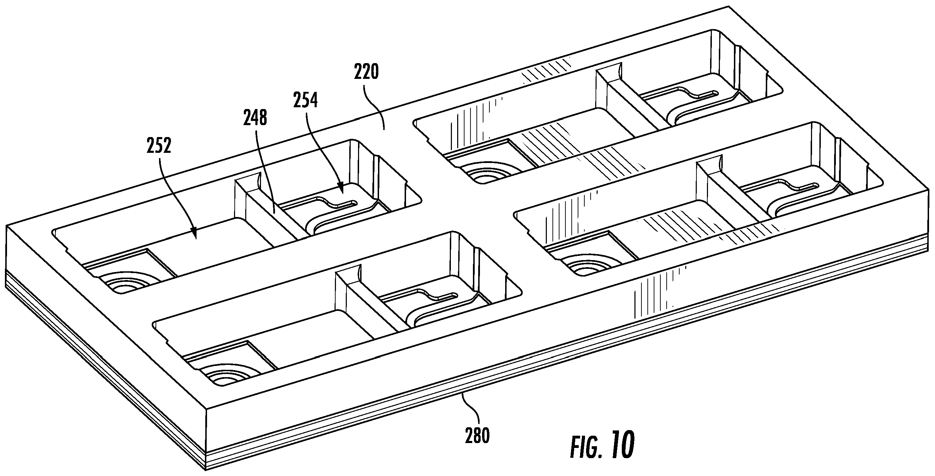

As described above, in alternative embodiments the wall layer may be a unitary structure that is constructed, for example, using a formative or additive process or any other suitable process (e.g., injection molding). Such a unitary wall structure may be directly formed onto the base layer or onto the cover layer or separately constructed and adhered to the base layer or cover layer. FIG. 10 illustrates such an alternative embodiment., with a unitary wall layer 220 formed on or adhered to an example cover layer 280. As seen in FIG. 10, the unitary wall layer 220 forms interior walls 248 and defines chambers such as sub-chambers 252, 254.

### Conclusion

Many modifications and other embodiments of the disclosures set forth herein will come to mind to one skilled in the art to which these disclosures pertain having the benefit of teachings presented in the foregoing descriptions and the associated drawings. Although the figures only show certain components of the apparatus and systems described herein, it is understood that various other components may be used in conjunction with the system. Therefore, it is to be understood that the disclosures are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. The disclosed embodiments relate primarily to fragmented wideband tympanometry techniques for true wireless stereo, however, one skilled in the art may recognize that such principles may be applied to any audio device. Alternative embodiments that result from combining, integrating, and/or omitting features of the embodiment(s) are also within the scope of the disclosure. Accordingly, the scope of protection is not limited by the description set out above.

Additionally, the section headings used herein are provided for consistency with the suggestions under 37 C.F.R. 1.77 or to otherwise provide organizational cues. These headings shall not limit or characterize the disclosure(s) set out in any claims that may issue from this disclosure.

While this detailed description has set forth some embodiments of the present disclosure, the appended claims cover other embodiments of the present disclosure which differ from the described embodiments according to various modifications and improvements. For example, the appended claims can cover any form of optical module, like proximity sensors, Time-of-Flight sensors, ambient light sensors, cameras, infrared sensors, and emitting modules. The appended claims can also cover other forms of micro-electromechanical system (MEMS) devices and sensors where such a construction is beneficial, for example MEMS microphones, pressure sensors, and temperature sensors.

Within the appended claims, unless the specific term "means for" or "step for" is used within a given claim, it is not intended that the claim be interpreted under 35 U.S.C. 112, paragraph 6.

## Claims

1. An assembly of a plurality of optical modules, the assembly comprising:
a base layer comprising one circuit board laminated substrate having a plurality of optical components mounted thereon, each of the plurality of optical components corresponding to a respective one of the plurality of optical modules;
a cover layer substantially parallel to the base layer and comprising one circuit board laminated substrate having a plurality of apertures defined therein, each of the plurality of apertures corresponding to a respective one of the plurality of optical modules and aligned with a respective one of the plurality of optical components; and
a wall layer coupled to the base layer and to the cover layer and forming a plurality of external walls for each of the plurality of optical modules;
wherein the base layer, the cover layer, and the wall layer together define a plurality of chambers, each of the plurality of chambers corresponding to a respective one of the plurality of optical modules.

2. The assembly of claim 1, wherein the wall layer comprises at least one circuit board laminated substrate.

3. The assembly of claim 2, wherein the wall layer comprises a plurality of sub-layers, each of the plurality of sub-layers comprising one circuit board laminated substrate.

4. The assembly of claim 3, wherein one or more of the plurality of sub-layers form one or more interior walls for each of the plurality of optical modules to divide each chamber of the plurality of optical modules into two or more sub-chambers.

5. The assembly of claim 4, wherein at least one of the one or more interior walls for each of the plurality of optical modules does not span from the base layer to the cover layer.

6. The assembly of claim 4, wherein the wall layer and/or at least one of the one or more interior walls for each of the plurality of optical modules form one or more mounting surfaces for a lens and/or a filter in each of the plurality of optical modules.

7. The assembly of claim 2, wherein a plurality of conductive vias are formed in the wall layer to conductively connect the base layer and the cover layer.

8. The assembly of claim 7, wherein at least one of the plurality of conductive vias forms a portion of an electric circuit for detecting displacement of the cover layer and/or displacement of a lens in each of the plurality of optical modules.

9. The assembly of claim 1, wherein the wall layer comprises a unitary wall layer formed on or affixed to the base layer and/or the cover layer.

10. The assembly of claim 1, further comprising a plurality of lenses affixed to an underside of the cover layer;
wherein each of the plurality of lenses is aligned with a respective one of the plurality of apertures; and
wherein at least a portion of an innermost sub-layer of the cover layer is removed to define an air vent from each chamber of each of the plurality of optical modules to a respective one of the plurality of apertures.

11. A method of constructing a plurality of optical modules, the method comprising:
constructing an assembly of a plurality of optical modules by coupling a base layer and a cover layer to a wall layer; and
singulating the assembly into separate optical modules;
wherein the base layer comprises one circuit board laminated substrate having a plurality of optical components mounted thereon, each of the plurality of optical components corresponding to a respective one of the plurality of optical modules;
wherein the cover layer is substantially parallel to the base layer and comprises one circuit board laminated substrate having a plurality of apertures defined therein, each of the plurality of apertures corresponding to a respective one of the plurality of optical modules and aligned with a respective one of the plurality of optical components;
wherein the wall layer forms a plurality of external walls for each of the plurality of optical modules; and
wherein the base layer, the cover layer, and the wall layer together define a plurality of chambers, each of the plurality of chambers corresponding to a respective one of the plurality of optical modules.

12. The method of claim 11, wherein the wall layer comprises at least one circuit board laminated substrate.

13. The method of claim 12, wherein the wall layer comprises a plurality of sub-layers, each of the plurality of sub-layers comprising one circuit board laminated substrate.

14. The method of claim 13, wherein one or more of the plurality of sub-layers form one or more interior walls for each of the plurality of optical modules to divide each chamber of the plurality of optical modules into two or more sub-chambers.

15. The method of claim 14, wherein at least one of the one or more interior walls for each of the plurality of optical modules does not span from the base layer to the cover layer.

16. The method of claim 14, wherein the wall layer and/or at least one of the one or more interior walls for each of the plurality of optical modules form one or more mounting surfaces for a lens and/or a filter in each of the plurality of optical modules.

17. The method of claim 12, wherein a plurality of conductive vias are formed in the wall layer to conductively connect the base layer and the cover layer.

18. The method of claim 17, wherein at least one of the plurality of conductive vias forms a portion of an electric circuit for detecting displacement of the cover layer and/or displacement of a lens in each of the plurality of optical modules.

19. The method of claim 11,further comprising forming the wall layer as a unitary structure directly on the base layer or the cover layer.

20. The method of claim 11, further comprising;
affixing each of a plurality of lenses to an underside of the cover layer such that each of the plurality of lenses is aligned with a respective one of the plurality of apertures; and
removing at least a portion of an innermost sub-layer of the cover layer to define an air vent from each chamber of each of the plurality of optical modules to a respective one of the plurality of apertures.
